# EUROPEAN PATENT SPECIFICATION

(11) **EP 0 674 224 B1**
(45) Date of publication and mention of the grant of the patent: **29.07.1998**
(21) Application number: 95101943.9
(22) Date of filing: 13.02.1995
(51) Int. Cl.: G03F 7/023

(54) **Photosensitive composition and image formation using the same**
Fotoempfindliche Zusammensetzung und Bilderzeugung damit
Composition photosensible et formation d'images utilisant cette composition

(30) Priority: 23.03.1994 JP 52112/94
(43) Date of publication of application: 27.09.1995
(73) Proprietor: FUJI PHOTO FILM CO., LTD., Kanagawa (JP)
(72) Inventor: Kawamura, Koichi, c/o Fuji Photo Film Co., Ltd., Haibara-gun, Shizuoka (JP); Takita, Satoshi, c/o Fuji Photo Film Co., Ltd., Haibara-gun, Shizuoka (JP); Miyake, Hideo, c/o Fuji Photo Film Co., Ltd., Haibara-gun, Shizuoka (JP); Sekiya, Toshiyuki, c/o Fuji Photo Film Co., Ltd., Haibara-gun, Shizuoka (JP); Akiyama, Keiji, c/o Fuji Photo Film Co., Ltd., Haibara-gun, Shizuoka (JP); Imaizumi, Mitsuhiro, c/o Fuji Photo Film Co., Ltd., Haibara-gun, Shizuoka (JP)
(74) Representative: Grünecker, Kinkeldey, Stockmair & Schwanhäusser Anwaltssozietät

(56) References cited:
- EP-A- 0 633 500
- DE-A- 3 742 387

## Description

The present invention relates to a photosensitive composition suitable for the production of lithographic plates, integrated circuits (IC) or photomasks. More particularly, the present invention relates to a photosensitive composition containing a photosensitive compound such as a o-naphthoquinonediazide compound, said photosensitive composition comprising a polymer soluble in an alkaline aqueous solution or an alkaline solvent mainly comprising water (hereinafter referred to as "alkali-soluble polymer").

A photosensitive composition comprising an o-naphthoquinonediazide compound and a novolak phenolic resin has heretofore been industrially used as an extremely excellent photosensitive composition in the production of lithographic plates or photoresists.

However, because of the properties of the novolak phenolic resin used as a main component, the photosensitive composition is disadvantageous in that it exhibits a poor adhesivity to the substrate and provides a brittle film having a poor abrasion resistance, giving an insufficient impression capacity. Thus, the photosensitive composition leaves much to be desired and there are practical limitations to it.

In order to solve these problems, various polymers have been studied as binders. For example, polyhydroxystyrene or hydroxystyrene copolymers disclosed in JP-B-52-41050 (the term "JP-B" as used herein means an "examined Japanese patent publication") undoubtedly provide improved film properties. However, these copolymers are disadvantageous in that they exhibit a poor abrasion resistance.

On the other hand, JP-A-63-226641 (the term "JP-A" as used herein means an "unexamined published Japanese patent application") discloses a positive-working photosensitive composition comprising an alkali-soluble polymer having an active imino group as a binder which allegedly exhibits improved film properties, adhesivity to the substrate and abrasion resistance. However, this positive-working photosensitive composition is disadvantageous in that it must be used in combination with a novolak resin which has heretofore been used to keep the range of proper development conditions wide. Thus, this positive-working photosensitive composition cannot always provide sufficient impression capacity.

Further, the conventional phenolic resin photosensitive composition normally must be developed with an alkaline aqueous solution having a pH of 13 or higher. Such a high pH developer is by no means desirable in the light of safety in handling or disposability of the used developer.

EP-A-0633500 (relevant with respect to Art. 54(3) EPC) discloses a positive-working photosensitive composition containing a polymer having at least 60 mol% structural units represented by the following formula

-(CH₂-CA((B)ₘ-(X)ₙ-NH-Y))-

wherein A represents a hydrogen atom, a halogen atom, or an alkyl group having 1 to 4 carbon atoms; B represents a phenylene group or a substituted phenylene group; X represents -CO- or -SO₂-; Y represents -CO-R₁ or -SO₂-R₁, where R₁ represents an alkyl group, a substituted alkyl group, an aromatic group, or a substituted aromatic group; and m and n each represents 0 or 1, provided that at least either is not 0.

It is an object of the present invention to provide a photosensitive composition which can be developed with an alkaline aqueous solution having a relatively low pH value and can provide a lithographic printing plate having great impression capacity.

It is another object of the present invention to provide a photosensitive composition which gives a flexible film having a good adhesivity to the substrate.

The above objects have been solved by providing a positive-working photosensitive composition, which comprises a polymer having a structural unit represented by the following formula [1] in a proportion of from 3 mol% to less than 60 mol%: 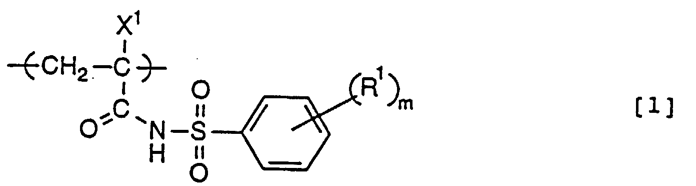 wherein
X¹ represents a hydrogen atom, a halogen atom or an alkyl group having from 1 to 4 carbon atoms;
R¹ represents an alkyl group having from 1 to 6 carbon atoms, a halogen atom or an alkoxy group having from 1 to 6 carbon atoms; and
m represents an integer of from 1 to 5,
with the proviso that said polymer is not represented by

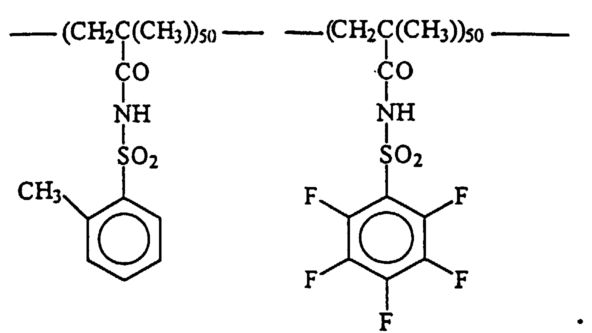

Moreover, the present invention provides a process for image formation, which comprises the steps of imagewise exposing a photosensitive material comprising a photosensitive layer containing the above-described photosensitive composition, and then developing the photosensitive material with an aqueous alkaline solution having a pH of 12.5 or less.

More preferably, the above-described positive-working photosensitive composition of the present invention comprises a polymer having the following structural units (a), (b) and (c) in a proportion of from 3 mol% to less than 60 mol%, from 3 mol% to 80 mol%, and from 3 mol% to 80 mol%, respectively:
(a) structural unit represented by the above-described formula [1];
(b) structural unit represented by the following formula [2]; and
(c) structural unit represented by the following formula [3]:

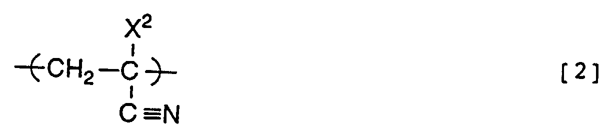

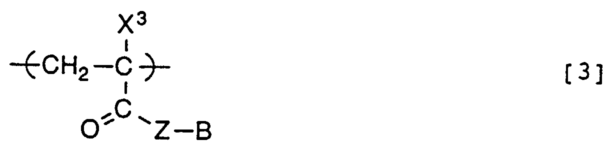

In formula [2], X² represents a hydrogen atom, a halogen atom or an alkyl group having from 1 to 4 carbon atoms.

In formula [3], X³ represents a hydrogen atom, a halogen atom or an alkyl group having from 1 to 4 carbon atoms. Z represents an oxygen atom or -NR²-, and R² represents a hydrogen atom or an alkyl group. B represents an alkyl group, a substituted alkyl group, an aromatic group, a substituted aromatic group, a heterocyclic group or a substituted heterocyclic group.

The polymer used in the present invention contains an active imino group having a specific structure represented by formula [1] in its molecular structure. The structural unit is contained in a proportion of from 3 mol% to less than 60 mol%. The active imino group undergoes dissociation to cause the polymer to be dissolved in an alkaline aqueous solution having a pH value of 12.5 or less.

The polymer containing an active imino group as a structural unit is described in JP-A-63-226641. Further, the polymer containing a specific active imino group as a structural unit is disclosed in Japanese Patent Application No. 5-170484. It has been found that a photosensitive composition comprising a polymer having this specific structural unit incorporated therein in a specific range can exhibit the following unexpectedly excellent properties. That is, when developed with an alkaline aqueous solution having a pH value of 12.5 or less, such a photosensitive composition can not only exert an excellent effect of forming an image but also exhibit an excellent abrasion resistance, particularly high impression capacity (press life).

In formula [1], X¹ represents a hydrogen atom, a halogen atom (e.g., fluorine, chlorine, bromine) or an alkyl group having from 1 to 4 carbon atoms (e.g., methyl, ethyl, propyl, isopropyl, n-butyl, isobutyl, t-butyl), preferably a hydrogen atom or a methyl group.

R¹ represents a straight-chain, branched or cyclic alkyl group having from 1 to 6 carbon atoms (e.g., methyl, ethyl, isopropyl, cyclohexyl), a halogen atom (e.g., fluorine, chlorine, bromine) or an alkoxy group having from 1 to 6 carbon atoms (e.g., methoxy, ethoxy), preferably a methyl group, an ethyl group, a fluorine atom, a chlorine atom, a methoxy group or an ethoxy group.

m represents an integer of from 1 to 5.

The polymer used in the present invention may exhibit a wide range of molecular weight, preferably from 1,000 to 1,000,000, more preferably from 4,000 to 500,000, as calculated in terms of weight-average molecular weight (Mw) determined by gel permeation chromatography with polystyrene as a standard or determined by light scattering in THF.

The content of the polymer having an active imino group in the photosensitive composition of the present invention is from 20 to 95% by weight, preferably from 50 to 90% by weight.

The copolymerizable components which constitute the polymer with the structural unit represented by formula [1] include a vinyl monomer. However, it is necessary that the structural unit represented by formula [1] be contained in a proportion of from 3 mol% to less than 60 mol%, preferably from 10 mol% to less than 60 mol%.

Representative examples of the foregoing vinyl monomer to be used in combination with the structural unit represented by formula [1] will be listed below.

Examples thereof include ethylenically unsaturated olefins (e.g., ethylene, propylene, isobutyrene, butadiene, isobutyrene);
styrenes (e.g., styrene, α-methylstyrene, o-methylstyrene, m-methylstyrene, p-methylstyrene, o-chlorostyrene, p-chlorostyrene);
acrylic acids and esters thereof (e.g., acrylic acid, methyl acrylate, ethyl acrylate, iso-butyl acrylate, n-butyl acrylate, hexyl acrylate, octyl acrylate, benzyl acylate, 2-hydroxyethyl acrylate, 2-cyanoethyl acrylate, glycidyl acrylate, dimethylaminoethyl acrylate);
methacrylic acids and esters thereof (e.g., methacrylic acid, methyl methacrylate, ethyl methacrylate, n-butyl methacrylate, iso-butyl methacrylate, tort-butyl methacrylate, hexyl methacrylate, 2-ethylhexyl methacrylate, lauryl methacrylate, tridecyl methacrylate, cyclohexyl methacrylate, benzyl methacrylate, 2-hydroxyethyl methacrylate, 2-hydroxypropyl methacrylate, dimethylaminoethyl methacrylate, diethylaminoethyl methacrylate, glycidyl methacrylate, tetrahydrofurfuryl methacrylate, allyl methacrylate);
vinylesters (e.g., vinyl acetate, vinyl propionate, vinyl butyrate, vinyl caproate, vinyl benzoate);
nitriles (e.g., acrylonitrile, methacrylonitrile);
vinylethers (e.g., methyl vinyl ether, ethyl vinyl ether, isobutyl vinyl ether, β-chloroethyl vinyl ether, cyclohexyl vinyl ether);
acrylamides (e.g., acrylamide, N-methylacrylamide, N,N-dimethylacrylamide, N-tert-butylacrylamide, N-octylacrylamide, diacetonacrylamide);
monomers having a phenolic hydroxyl group (e.g., p-hydroxyphenylacrylamide, o-hydroxyphenylacrylamide, p-hydroxyphenylacrylamide, p-hydroxyphenyl acrylate, those described in JP-A-64-35436 and JP-B-52-34932); and
monomers having a sulfamoyl group (e.g., N-(p-sulfamoylphenyl)methacrylamide, N-(p-sulfamoylphenyl)-acrylamide).

Further, coupler monomers as described in Japanese Patent Application No. 6-37206 are useful.

Particularly preferred examples of the structural units which can be used in combination with the structural unit represented by formula [1] are those obtained by the polymerization of vinyl monomers represented by the following formulae [2a] and [3a]:

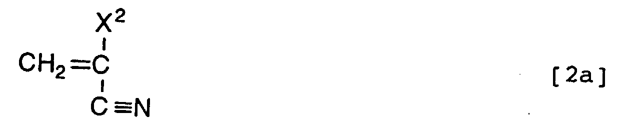

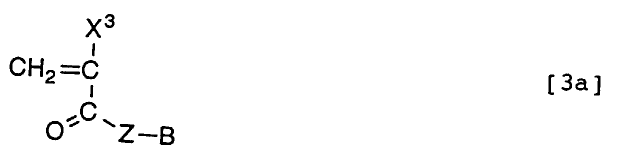

In formulae [2a] and [3a], X², X³, Z and B are the same as those defined in formulae [2] and [3].

The alkyl moiety of the substituted or unsubstituted alkyl group represented by B has preferably from 1 to 9 carbon atoms. Preferred examples of the substituents of the substituted alkyl group represented by B include a halogen atom, an alkoxy group, a substituted alkoxy group, a hydroxyl group, an acetoxy group, a phenyl group, and a substituted phenyl group. Preferred examples of the substituted or unsubstituted aromatic group represented by B include a phenyl group, a substituted phenyl group, a naphthyl group, and a substituted naphthyl group. Preferred examples of the heterocyclic group represented by B include 5- to 7-membered monocyclic or polycyclic heterocyclic groups having at least one of nitrogen, oxygen and sulfur atoms. Preferred examples of the substituents of the substituted aromatic and heterocyclic groups include those recited above with regard to the substituted alkyl group.

In formulae [2a] and [3a], particularly preferred examples of X² and X³ include a hydrogen atom and a methyl group. Particularly preferred examples of Z include an oxygen atom and -NH-. Particularly preferred examples of B include an unsubstituted alkyl group; an alkyl group substituted by at least one of a halogen atom, an alkoxy group, a substituted alkoxy group, a hydroxyl group, a phenyl group and a substituted phenyl group; a phenyl group; and a 5- to 7-membered monocyclic or polycyclic heterocyclic group containing a nitrogen atom.

Preferred examples of the compound represented by formula [2a] include acrylonitrile and methacrylonitrile.

Preferred examples of the compound represented by formula [3a] include methyl acrylate, ethyl acrylate, butyl acrylate, benzyl acrylate, methacrylic acid, methyl methacrylate, ethyl methacrylate, butyl methacrylate, benzyl methacrylate, hydroxyethyl methacrylate, acrylic ester of diethylene glycol monomethyl ether, N-(p-sulfamoylphenyl)-methacrylamide, N-(p-sulfamoylphenyl)acrylamide, and a coupler monomer represented by the following formula [4a]:

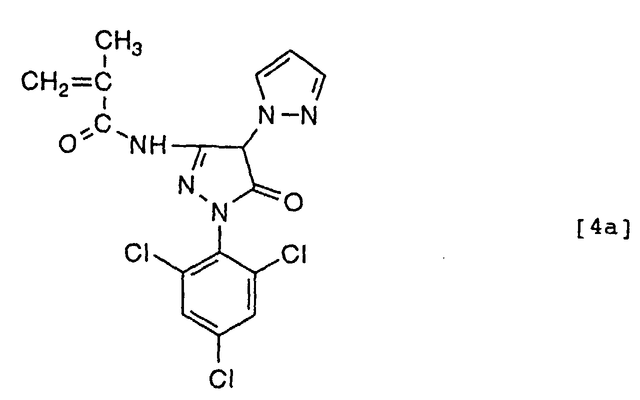

In the present invention, a polymer containing one of structural units represented by formulae [2] and [3] together with the structural unit represented by formula [1] may be used.

In a particularly preferred embodiment, a polymer containing at least both the structural units represented by formulae [2] and [3] together with the structural unit represented by formula [1] may be used.

The proportions of the structural units represented by formulae [2] and [3] in the polymer are each from 3 mol% to 80 mol%, preferably from 5 mol% to 70 mol%.

Representative examples of the polymer containing an active imino group used in the present invention will be listed below.

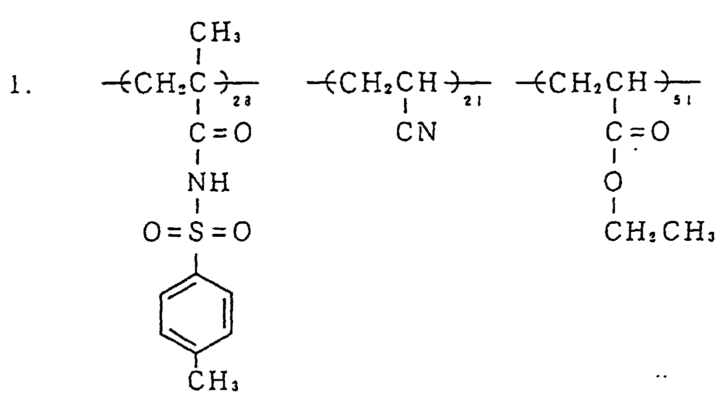

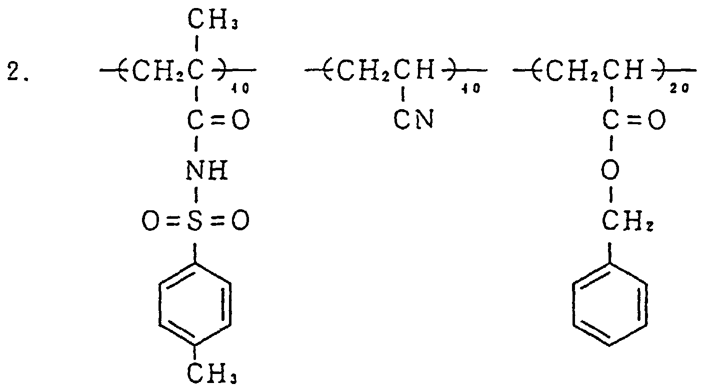

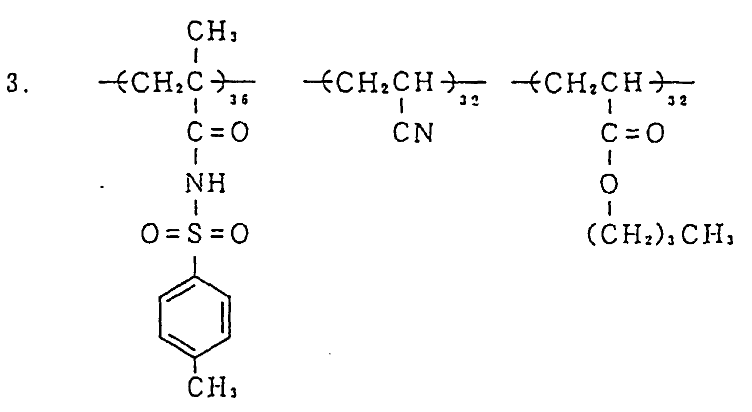

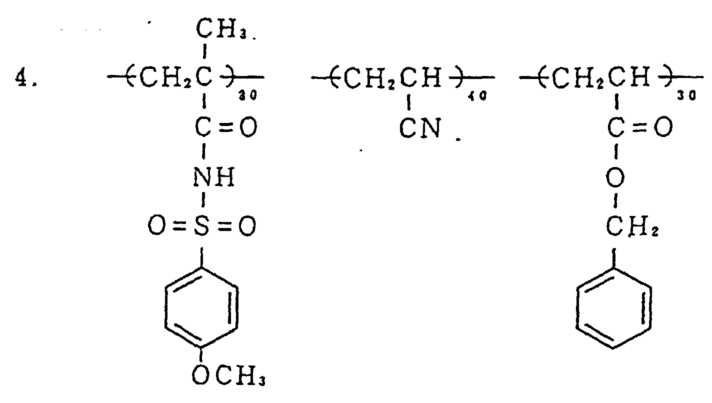

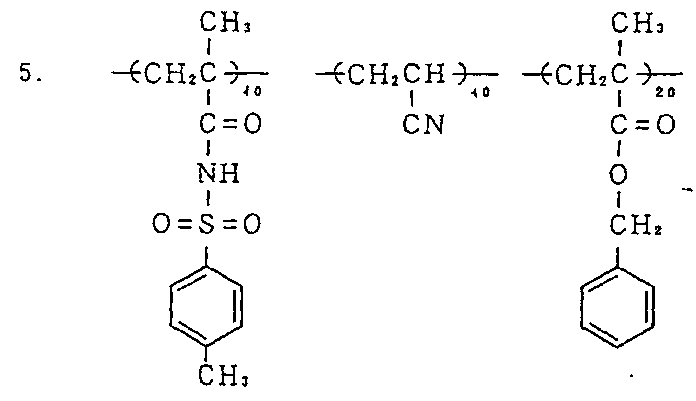

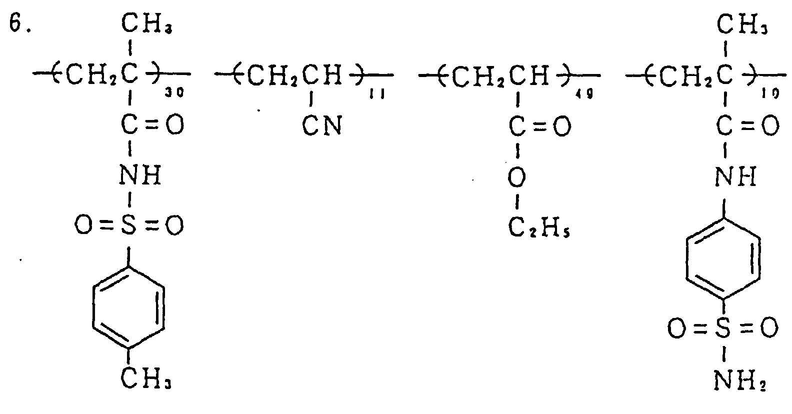

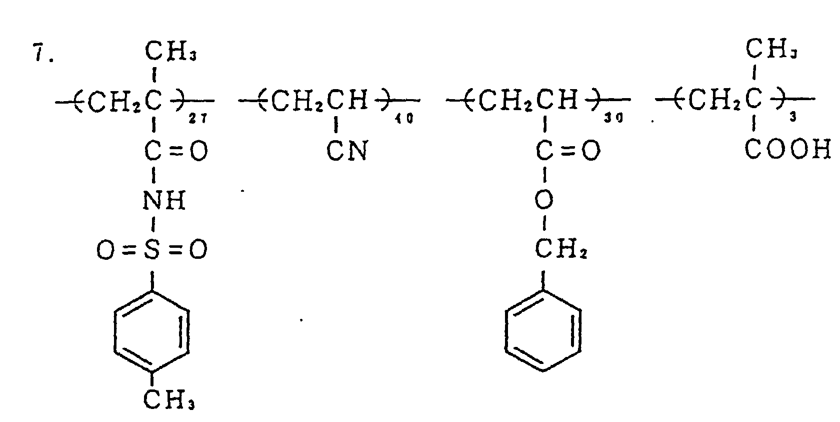

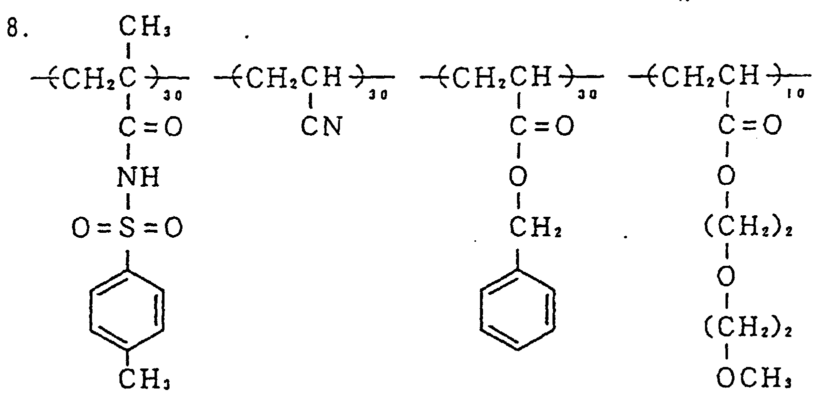

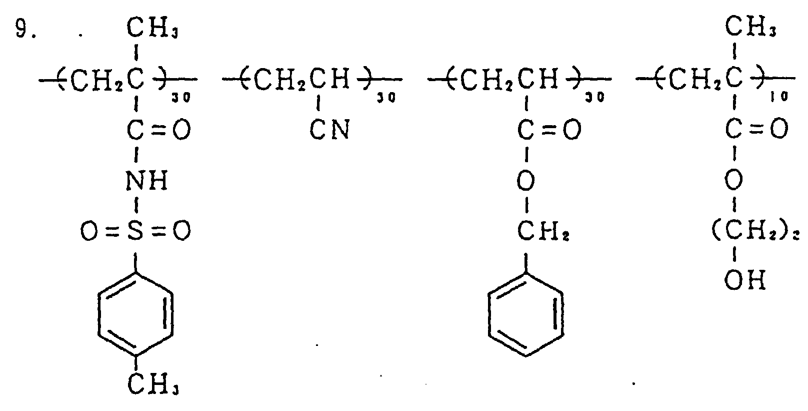

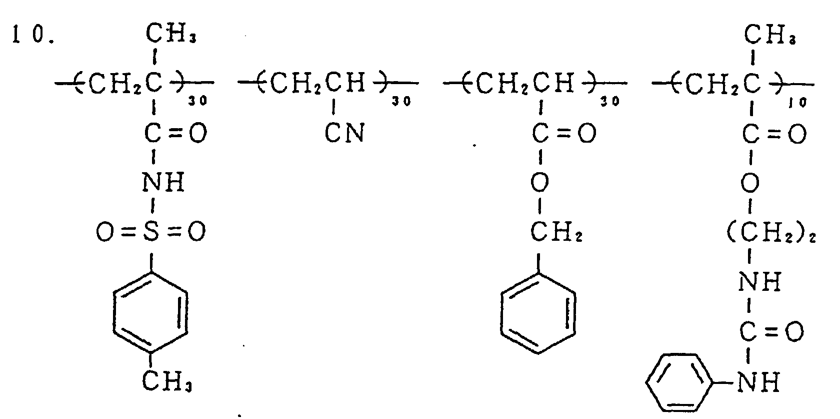

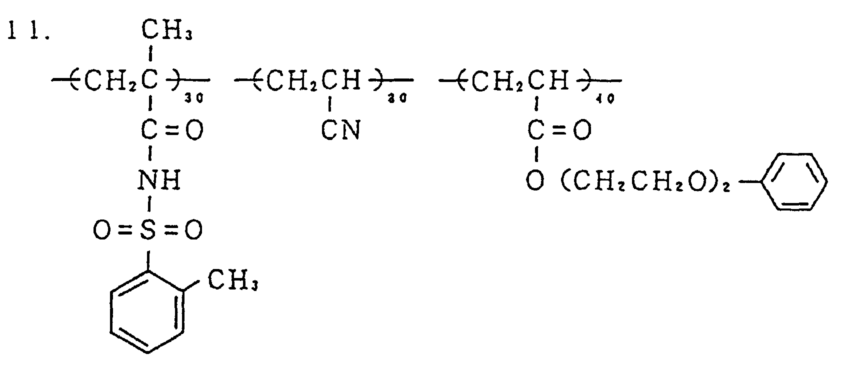

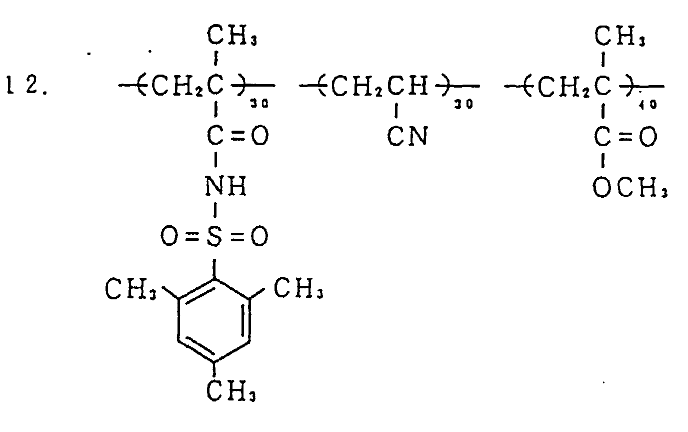

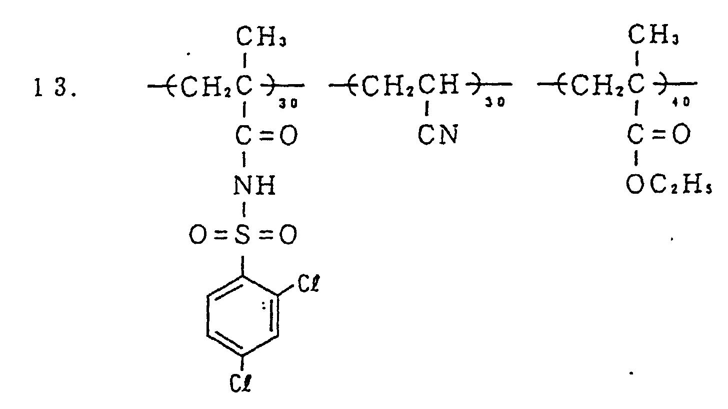

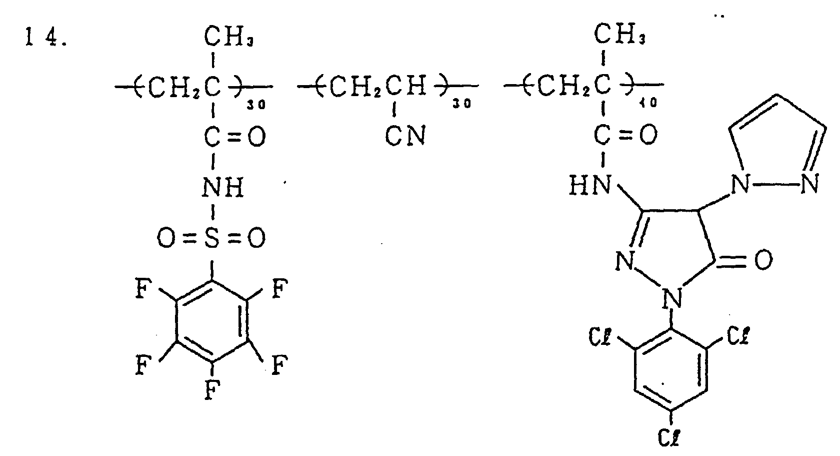

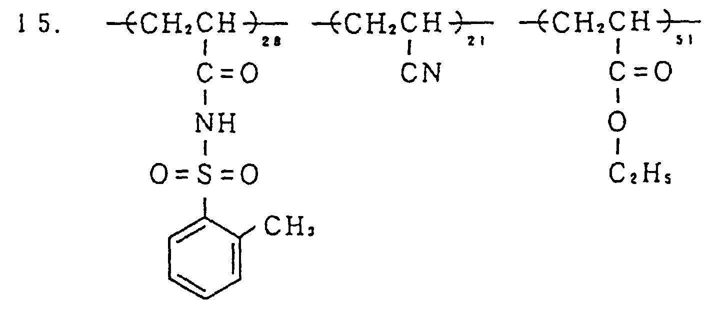

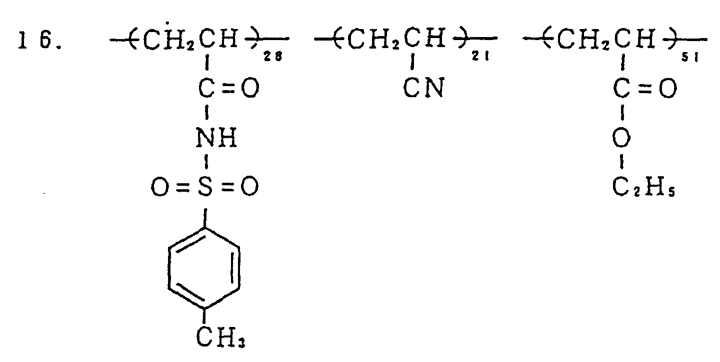

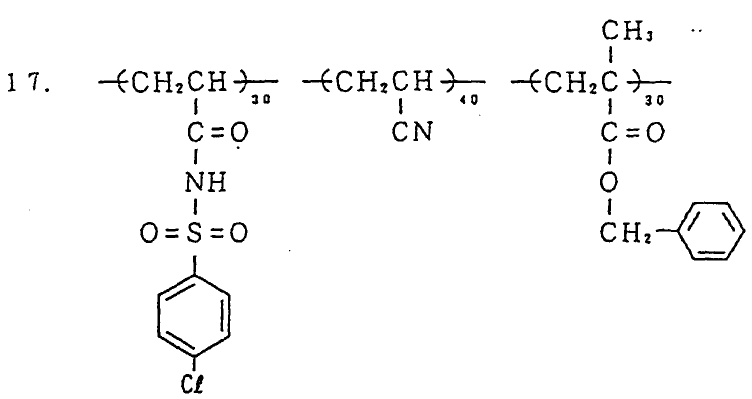

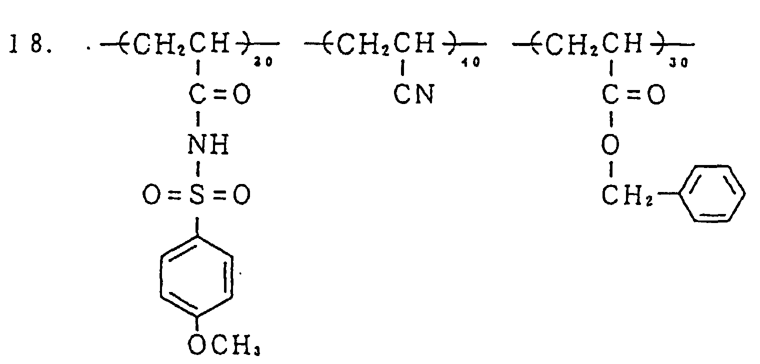

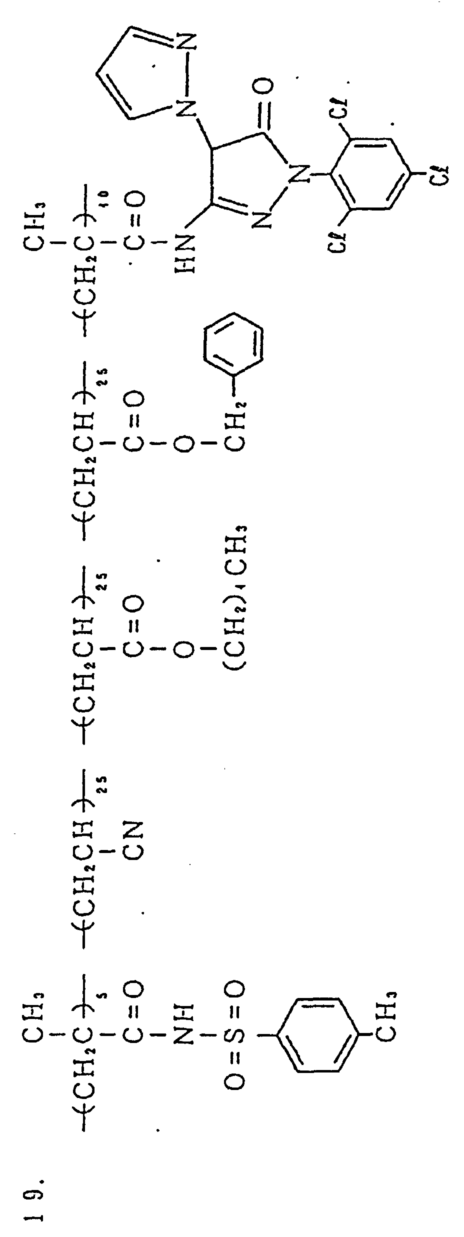

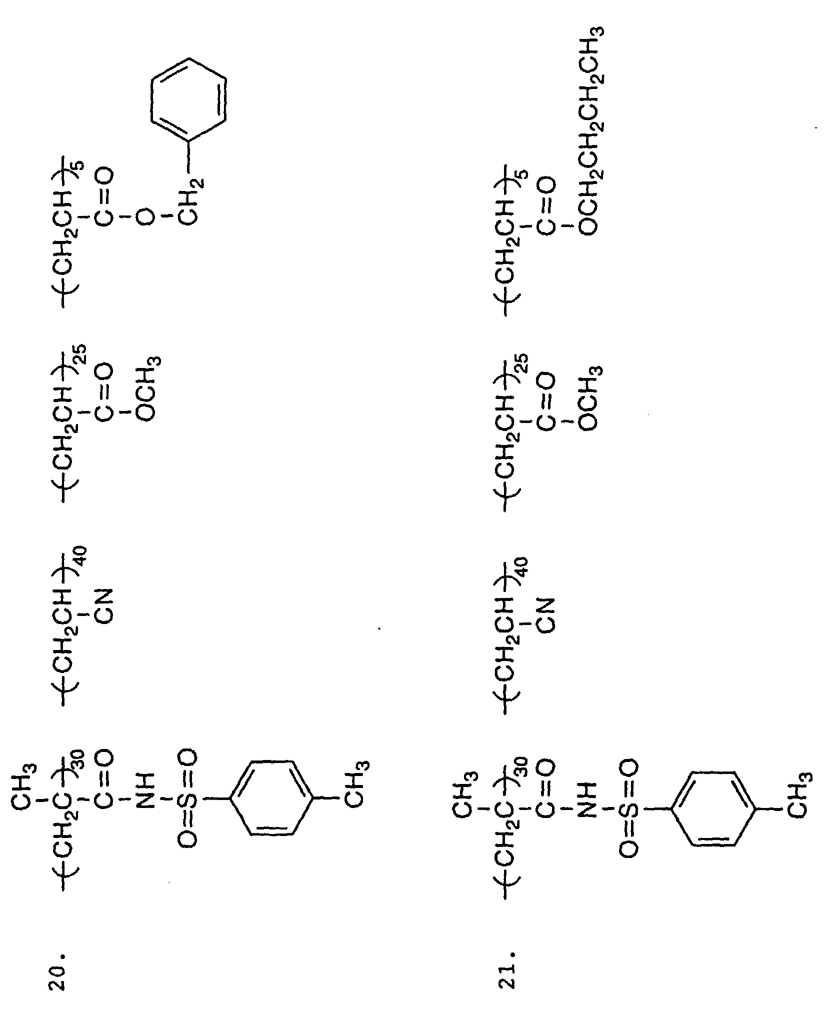

Representative examples of synthesis of the polymer containing an active imino group used in the present invention will be described hereinafter.

### SYNTHESIS EXAMPLE 1. Synthesis of Example Polymer 1

In 232.6 g of dimethylformamide, 60.3 g of N-(p-toluenesulfonyl)methacrylamide, 10.0 g of acrylonitrile and 46.0 g of ethyl acrylate were dissolved. The reaction solution was then stirred at a temperature of 65°C by adding 0.224 g of 2,2'-azobis(2,4-dimethylvaleronitrile) as a polymerization initiator in a stream of nitrogen for 7 hours. The reaction solution was allowed to cool, and then reprecipitated with 5 ℓ of water. The resulting polymer was recovered by filtration, and then dried to obtain 110.4 g of Example Polymer 1 (yield: 95%; Mw: 52,000).

The positive-working photosensitive compound used in the present invention is preferably an o-naphthoquinonediazide compound. Examples of the o-naphthoquinonediazide compounds include ester of 1,2-diazonaphthoquinonesulfonic chloride with pyrogallol-acetone resin and ester of 1,2-diazonaphthoquinonesulfonic chloride with 2,3,4-trihydroxybenzophenone as disclosed in JP-B-43-28403.

Other preferred examples of o-naphthoquinonediazide compounds include ester of chloride 1,2-diazonaphthoquinonesulfonate with phenol-formaldehyde resins disclosed in US-A-3,046,120 and 3,188,210. Other useful examples of o-naphthoquinonediazide compounds which can be used in the present invention include those reported in many patents and known in the art. Examples of these o-naphthoquinonediazide compounds include those described in JP-A-47-5303, JP-A-48-63802, JP-A-48-63803, JP-A-48-96575, JP-A-49-38701, JP-A-48-13354, JP-B-41-11222, JP-B-45-9610, JP-B-49-17481, US-A-2,797,213, 3,454,400, 3,544,323, 3,573,917, 3,674,495 and 3,785,825, GB-A-1,227,602, 1,251,345, 1,267,005, 1,329,888 and 1,330,932, and DE-A-854,890.

Other examples of positive-working photosensitive compounds other than o-naphthoquinonediazide compounds which can be used in the present invention include polymer compounds having an o-nitrocarbinol ester group disclosed in JP-B-56-2696.

Further, a mixture of a compound which undergoes photodecomposition to produce an acid with a compound having a C-O-C group or a C-O-Si group which undergoes dissociation when acted upon by an acid can be used in the present invention. Examples of such a mixture include combinations of a compound which undergoes photodecomposition to produce an acid with an acetal or O,N-acetal compound (disclosed in JP-A-48-89003), an orthoester or amide acetal compound (disclosed in JP-A-51-120714), a polymer having an acetal or ketal group in its main chain (disclosed in JP-A-53-133429), an enol ether compound (disclosed in JP-A-55-12995), an N-acyliminocarbonic acid compound (disclosed in JP-A-55-126236), a polymer having an ortho ester group in its main chain (disclosed in JP-A-56-17345), a silyl ester compound (disclosed in JP-A-60-10247), and a silyl ether compound (disclosed in JP-A-60-37549, JP-A-60-121446).

Such a positive-working photosensitive compound or a photosensitive compound mixture is preferably incorporated in the photosensitive composition in an amount of from 5 to 80% by weight, more preferably from 10 to 50% by weight, based on the weight of the photosensitive composition.

The composition according to the present invention may contain a known aqueous alkali-soluble high molecular compound such as phenolformaldehyde resin, cresolformaldehyde resin, phenol-modified xylene resin, polyhydroxystyrene and polyhalogenated hydroxystyrene other than the polymer of the present invention. Such an aqueous alkali-soluble high molecular compound is preferably incorporated in the polymer having a structural unit represented by formula [1] in an amount of from 0 to 1000% by weight, more preferably from 0 to 300% by weight, based on the weight of the polymer containing the structural unit represented by formula [1] in a proportion of from 3 mol% to less than 60 mol%.

The composition according to the present invention may further comprise various additives such as a cyclic anhydrous acid for enhancing sensitivity, a printing-out agent for providing a visible image shortly after exposure, a dye as an image colorant, and other fillers. Examples of the cyclic anhydrous acid include phthalic anhydride, tetrahydrophthalate anhydride, hexahydrophthalate anhydride, 3,6-endoxy-Δ⁴-tetrahydrophthalate anhydride, tetrachlorophthalate anhydride, maleic anhydride, chloromaleic anhydride, α-phenylmaleic anhydride, succinic anhydride, and pyromellitic acid.

Such a cyclic anhydrous acid can be incorporated in the photosensitive composition in an amount of from 1 to 15% by weight based on the total weight of the photosensitive composition to enhance the sensitivity by a factor of 3 at maximum. A typical example of the printing-out agent for providing a visible image shortly after exposure is a combination of a photosensitive compound which undergoes exposure to release an acid with an organic dye capable of forming a salt with the photosensitive compound. Specific examples of such a combination include a combination of an o-naphthoquinonediazide-4-sulfonic halogenide with a salt-forming organic dye described in JP-A-50-36209 and JP-A-53-8128, and a combination of a trihalomethyl compound with a salt-forming organic dye described in JP-A-53-36223 and JP-A-54-74728. As the image colorant, other dyes as well as the salt-forming organic dye may be used. Examples of suitable dyes containing a salt-forming organic dye as well include various oil-soluble dyes and basic dyes. Specific examples of these dyes include Oil Yellow #101, Oil Yellow #130, Oil Pink #312, Oil Green BG, Oil Blue BOS, Oil Blue #603, Oil Black BY, Oil Black BS, Oil Black T-505 (available from Orient Chemical Industry Co., Ltd.), Crystal Violet (CI42555), Methyl Violet (CI42535), Rhodamine B (CI45170B), Malachite Green (CI42000), and Methylene Blue (CI52015).

The photosensitive composition according to the present invention may contain various additives. Examples thereof include alkylethers (e.g., ethyl cellulose, methyl cellulose), fluorinic surface active agents (e.g., preferably those described in JP-A-62-170950) and nonionic surface active agents (e.g., preferably fluorinic surface active agents) for improving coatability, plasticizers for providing coat flexibility and abrasion resistance (e.g., butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, acrylic or methacrylic oligomer and polymer; particularly among these plasticizers is tricresyl phosphate), ink-receptible agents for enhancing the ink-receptivity of the image area (e.g., compounds obtained by half-esterification of styrene-maleic anhydride by alcohol, octylphenolformaldehyde novolak resins and compounds obtained by 50% aliphatic esterification of p-hydroxystyrene as disclosed in JP-A-55-527), may be preferably used. The amount of these additives to be added depends on the purpose but generally is from 0.01 to 30% by weight based on the total solid content in the composition.

The photosensitive composition according to the present invention is solved in a solvent capable of dissolving the foregoing various components, and then coated on a support. Examples of the solvents employable herein include ethylene dichloride, cyclohexanone, methyl ethyl ketone, ethylene glycol monomethyl ether, propylene glycol monomethyl ether, ethylene glycol monoethyl ether, 2-methoxyethyl ether, ethylene glycol monoethyl ether, 2-methoxyethyl acetate, propylene glycol monomethyl ether acetate, diethylene glycol monomethyl ether acetate, toluene, and ethyl acetate. These solvents may be used singly or in combination with one or more thereof. The concentration (solid content) of the foregoing components in the solution is preferably from 2 to 50% by weight. The coated amount of the photosensitive composition depends on the purpose. For example, it is preferably from 0.5 to 3.0 g/m² as calculated in terms of solid content in the case of photosensitive lithographic printing plate. The less the coated amount of the photosensitive composition is, the greater is the sensitivity but the poorer are the physical properties of the photosensitive layer.

The photosensitive composition is particularly suitable as a photosensitive layer for a photosensitive lithographic printing plate. Embodiments of photosensitive lithographic printing plates will be further described hereinafter.

The support to be used in the present invention is preferably a dimensionally stable sheet material. As such a dimensionally stable sheet material, one which has been heretofore used as a support for printed matter is preferably used. Examples of such a support include paper, paper laminated with plastics (e.g., polyethylene, polypropylene, polystyrene), metal plate such as aluminum (including aluminum alloy), zinc and copper plates, plastic film such as cellulose diacetate, cellulose triacetate, cellulose propionate, cellulose acetate, cellulose acetate butyrate, cellulose nitrate, polyethylene terephthalate, polyethylene, polystyrene, polypropylene, polycarbonate and polyvinyl acetal, and paper or plastic film laminated with or vapor-metallized by the foregoing metals. Among these supports, an aluminum plate is remarkably stable in dimension and inexpensive and has an excellent adhesion to the photosensitive layer used in the present invention, and thus can be preferably used in the present invention. Further, a composite sheet having an aluminum sheet laminated on a polyethylene terephthalate film disclosed in JP-B-48-18327 may also be used.

A metallic support, particularly an aluminum support, is preferably subjected to surface processing such as graining and anodic oxidation. Further, in order to enhance the hydrophilicity of the surface of the metallic support, it may be dipped in an aqueous solution of sodium silicate, potassium zirconium fluoride or phosphate. An aluminum plate which has been grained and then dipped in an aqueous solution of sodium silicate as described in US-A-2,714,066 and an aluminum plate which has been anodically oxidized and then dipped in an aqueous solution of silicate of alkaline metal as described in JP-B-47-5125 are preferable. Moreover, silicate electrodeposition described in US-A-3,658,662, and a combination of electrolytic graining with the foregoing anodic oxidation and sodium silicate processing disclosed in JP-B-46-27481, JP-A-52-58602 and JP-A-52-30503 are useful surface processing. Further, a sequential combination of brush graining, electrolytic graining, anodic oxidation, and sodium silicate processing disclosed in JP-A-56-28893 can be preferably used.

The aluminum plate may be optionally provided with an organic undercoating layer before being coated with a photosensitive layer. Examples of the organic compounds which can be incorporated into this organic undercoating layer include carboxymethyl cellulose; dextrin; gum arabic; phosphonic acids having amino group such as 2-aminoethylphosphonic acid; organic phosphonic acids such as phenylphosphonic acid, naphthylphosphonic acid, alkylphosphonic acid, glycerophosphonic acid, methylenediphosphonic acid and ethylenediphosphonic acid which may have one or more substituents; organic ester phosphates such as phenylphosphoric acid, naphthylphosphoric acid, alkylphosphoric acid and glycerophosphoric acid which may have one or more substituents; organic phosphinic acids such as phenylphosphinic acid, naphthylphosphinic acid, alkylphosphinic acid and glycerophosphinic acid which may have one or more substituents; amino acids such as glycine and β-alanine; and hydrochlorides of hydroxyl-containing amine such as hydrochloride of triethanolamine. These organic compounds may be used singly or in combination with one or more thereof. JP-A-4-282637 discloses the examples using phenylphosphoric acid and phenylphosphonic acid among these organic compounds.

The foregoing organic undercoating layer may be provided in the following manner. In more detail, the foregoing organic compound may be coated on an aluminum plate in the form of solution in water, an organic solvent such as methanol, ethanol and methyl ethyl ketone or a mixture thereof, and then dried to form an organic undercoating layer. Alternatively, an aluminum plate may be dipped in a solution of the foregoing organic compound in water, an organic solvent such as methanol, ethanol and methyl ethyl ketone or a mixture thereof so that the foregoing organic compound is adsorbed to the aluminum plate. The aluminum plate is washed with, for example, water, and then dried to form an organic undercoating layer. In the former process, a solution of the foregoing organic compound having a concentration of from 0.005 to 10% by weight can be coated on the aluminum plate by various methods. For example, any of bar coating, rotary coating, spray coating and curtain coating may be used. In the latter process, the aluminum plate may be dipped in a solution of the foregoing organic compound having a concentration of from 0.01 to 20% by weight, preferably from 0.05 to 5% by weight at a temperature of from 20 to 90°C, preferably from 25 to 50°C for 0.1 second to 20 minutes, preferably 2 seconds to 1 minute to form an organic undercoating layer.

The foregoing solution may be adjusted with a basic substance such as ammonia, triethylamine and potassium hydroxide or an acidic substance such as hydrochloric acid and phosphoric acid to a pH of 1 to 12 before use. A yellow dye may be added to the solution to improve the tone reproducibility of the photosensitive lithographic printing plate.

The coated amount of the organic undercoating layer in dried form is preferably from 2 to 200 mg/m², more preferably from 5 to 100 mg/m². When this amount is less than 2 mg/m², sufficient press life cannot be obtained. On the contrary, when this amount exceeds 200 mg/m², similar problems occur.

In addition to the support for the photosensitive lithographic printing plate, the support which is processed with an aqueous alkali metal silicate solution and an aqueous acid solution as described in JP-A-5-278362 can be used.

The surface of the photosensitive layer on the photosensitive lithographic printing plate is preferably matted to shorten the time required for evacuation upon contact exposure using a vacuum printing frame and inhibit lack of sharpness in printing. In more detail, a process which comprises the provision of a matting layer on the surface of the photosensitive layer as described in JP-A-50-125805, JP-B-57-6582 and JP-B-61-28986, and a process which comprises the heat fusion of a solid powder to the surface of the photosensitive layer as described in JP-B-62-62337 may be used.

Examples of light sources to be used for imagewise exposure of the photosensitive lithographic printing plate include a carbon arc lamp, a mercury vapor lamp, a xenon lamp, a tungsten lamp, and a metal halide lamp.

As the developer for the photosensitive lithographic printing plate, an alkaline aqueous solution having a pH of 12.5 or less, preferably from 8 to 11 is used. Examples of the basic compounds employable to attain such a pH range include phosphates such as sodium tertiary phosphate, potassium tertiary phosphate, ammonium tertiary phosphate, sodium secondary phosphate, potassium secondary phosphate and ammonium secondary phosphate; carbonates such as ammonium hydrogencarbonate, sodium carbonate, potassium carbonate, ammonium carbonate, sodium hydrogencarbonate and potassium hydrogencarbonate; borates such as sodium borate, potassium borate and ammonium borate; and hydroxides of alkaline metals such as potassium hydroxide, sodium hydroxide, lithium hydroxide and ammonium hydroxide. A particularly preferred example of the basic compound is a combination of carbonate with hydrogencarbonate. These basic compounds are used singly or in combination with one or more thereof.

Other examples of the basic compounds which can be used in the present invention include water-soluble organic amine compounds such as monomethylamine, dimethylamine, trimethylamine, monoethylamine, diethylamine, triethylamine, monoisopropylamine, diisopropylamine, n-butylamine, monoethanolamine, diethanolamine, triethanolamine, monoisopropanolamine, diisopropanolamine, ethyleneimine, ethylenediamine and pyridine. More preferred among these basic compounds are monoethanolamine, diethanolamine, and triethanolamine. These basic compounds may be used in combination with an inorganic alkaline metal salt.

The concentration of such a basic compound in the aqueous solution may be such that the aqueous solution has a pH of 12.5 or less, preferably 8 to 11 as previously mentioned but is generally from 0.05 to 10% by weight.

If necessary, the developer may comprise an anionic surface active agent incorporated therein. Examples of such an anionic surface active agent include salts of sulfuric esters of higher alcohols having from 8 to 22 carbon atoms such as sodium salt of lauryl alcohol sulfate, sodium salt of octyl alcohol sulfate, ammonium salt of lauryl alcohol sulfate and secondary sodium alkyl sulfate; salts of aliphatic alcohol phosphoric esters such as sodium salt of cetyl alcohol phosphoric ester; alkylarylsulfonates such as sodium salt of dodecylbenzenesulfonate, sodium salt of isopropylnaphthalene-sulfonate and sodium salt of metanitrobenzenesulfonate; sulfonates of alkylamides such as C₁₇H₃₃CON(CH₃)CH₂CH₂SO₃Na; and sulfonates of dibasic aliphatic esters such as sodium sulfosuccinate dioctyl ester and sodium sulfosuccinate dihexyl ester.

Such an anionic surface active agent is preferably incorporated into the developer in an amount of from 0.1 to 5% by weight based on the total weight of the developer in the usable form. When this amount is less than 0.1% by weight, the predetermined effect of the anionic surface active agent is reduced. On the contrary, when this amount exceeds 5% by weight, it causes excess elution of dye in the image area (decoloration) or troubles such as deterioration of mechanical strength (e.g., abrasion resistance) and chemical strength of image.

As an organic solvent, one having a solubility of 10% or less by weight, more preferably 5% by weight or less, is preferably used. Examples of such an organic solvent include 1-phenylethanol, 2-phenylethanol, 3-phenylpropanol, 4-phenyl-1-butanol, 4-phenyl-1-butanol, 4-phenyl-2-butanol, 2-phenyl-1-butanol, 2-phenoxyethanol, 2-benzyloxyethanol, o-methoxybenzylalcohol, m-methoxybenzylalcohol, p-methoxybenzylalcohol, benzylalcohol, cyclohexanol, 2-methylcyclohexanol, 4-methylcyclohexanol and 3-methylcyclohexanol.

The content of such an organic solvent is preferably from 1 to 5% by weight based on the total weight of the developer in the usable form. The amount of the organic solvent to be used is closely related to the amount of the anionic surface active agent to be used. As the amount of the organic solvent to be used increases, the amount of the anionic surface active agent to be used is preferably increased. This is because, when such an organic solvent is used in a large amount while the anionic surface active agent is used in a small amount, it cannot be dissolved in the developer, making it impossible to provide an excellent developability.

Moreover, the developer may comprise additives such as anti-foam fluid and water softener incorporated therein. Examples of such a water softener include polyphosphates such as Na₂P₂O₇, Na₅P₃O₃, Na₃P₃O₉, Na₂O₄P(NaO₃P)PO₃Na₂ and Calgon® (sodium polmetaphosphate); aminopolycarboxylic acids (e.g., ethylenediaminetetraacetic acid, potassium salt thereof, sodium salt thereof; diethylenetriaminepentaacetic acid, potassium salt thereof, sodium salt thereof; triethylenetetraaminehexaacetic acid, potassium salt thereof, sodium salt thereof; hydroxyethylethylenediaminetriacetic acid, potassium salt thereof, sodium salt thereof; nitrilotriacetic acid, potassium salt thereof, sodium salt thereof; 1,2-diaminocyclohexanetetraacetic acid, potassium salt thereof, sodium salt thereof; 1,3-diamino-2-propanoltetraacetic acid, potassium salt thereof, and sodium salt thereof) and organic phosphonic acids (e.g., 2-phosphonobutane-1,2,4-tricarboxylate, potassium salt thereof, sodium salt thereof; 2-phosphonobutane-2,3,4-tricarboxylate, potassium salt thereof, sodium salt thereof; 1-phosphonoethane-1,2,2-tricarboxylate, potassium salt thereof, sodium salt thereof; 1-hydroxyethane-1,1-diphosphonate, potassium salt thereof, sodium salt thereof; aminotri(methylenephosphonic acid), potassium salt thereof, and sodium salt thereof). The amount of such a water softener to be used depends on the hardness and amount of water used but generally is preferably from 0.01 to 5% by weight, preferably 0.01 to 0.5% by weight, based on the weight of the developer in the usable form.

It goes without saying that the photosensitive lithographic printing plate can be subjected to plate-making processing in accordance with various methods described in JP-A-54-8002, JP-A-55-115045 and JP-A-59-58431. In more detail, the photosensitive lithographic printing plate which has been developed may be subjected to desensitizing processing immediately or after rinsing or to processing with an aqueous solution containing an acid optionally followed by desensitizing processing. Further, since the developer is exhausted as the processing proceeds in the development of this kind of a photosensitive lithographic printing plate, a developer replenisher or a fresh developer may be added to the developer to restore the processing capacity of the developer. In this case, a method described in US-A-4,882,246 may be preferably used to effect replenishment.

The foregoing plate-making processing may be preferably effected by means of an automatic developing machine described in JP-A-2-7054 and JP-A-2-32357.

When the photosensitive lithographic printing plate is subjected to deletion of unnecessary image area after imagewise exposure, development, washing with water or rinse, a deletion fluid described in JP-B-2-13293 may be preferably used. As a desensitizing gum to be optionally coated at the final step in the plate-making process, those described in JP-B-62-16834, JP-B-62-25118, JP-B-63-52600, JP-A-62-7595, JP-A-2-11693 and JP-A-62-83194 are preferably used.

Further, when the photosensitive lithographic printing plate is imagewise exposed to light, developed, washed with water or rinsed, optionally subjected to deletion, washed with water, and then subjected to burning, it is preferably processed with a burning conditioner disclosed in JP-B-61-2518, JP-B-55-28062, JP-A-31859 and JP-A-61-159655.

The present invention will be further described in the following examples. The term "%" as used in the following examples is meant to indicate "% by weight" unless otherwise specified.

### EXAMPLES 1 - 4

The surface of a 0.30-mm thick aluminum plate was grained with a nylon brush and an aqueous suspension of 400-mesh pumice stone, and then thoroughly washed with water. The aluminum plate thus grained was then dipped in a 10% aqueous solution of sodium hydroxide at a temperature of 70°C for 60 seconds so that it was etched. The aluminum plate thus etched was washed with running water, neutralized and washed with 20% HNO₂, and then washed with water. The aluminum plate was then electrolytically roughened in a 1% aqueous solution of nitric acid with a sinusoidal alternating current at an anodization electricity of 160 coulomb/dm² under the condition of V_{A} = 12.7 V. The aluminum plate thus roughened was then measured for surface roughness. The result was 0.6 µm (as represented by Rₐ). Subsequently, the aluminum plate was dipped in a 30% aqueous solution of H₂SO₄ at a temperature of 55°C for 2 minutes so that it was desmutted. The aluminum plate thus desmutted was then anodized in a 20% aqueous solution of H₂SO₄ at a current density of 2 A/dm² until the thickness of the anodized film reached 2.7 g/m². The aluminum plate thus anodized was dipped in a 2.5% aqueous solution of sodium silicate at a temperature of 70°C for 1 minute, washed with water, and then dried. The surface of the substrate thus treated was coated with an undercoating solution (A) having the following formulation, and then dried at a temperature of 80°C for 30 minutes. The coated amount after drying was 30 mg/m².

| | |
|---|---|
| Phenylphosphonic acid | 0.10 g |
| Methanol | 40 g |
| Pure water | 60 g |

Thus, a substrate (I) was prepared.

The following photosensitive solutions (A) were each applied to the substrate (I) to a thickness of 25 mℓ/m² by means of a rod coater, and then dried at a temperature of 100°C for 1 minute to obtain positive-working photosensitive lithographic plates. The coated amount after drying was about 1.7 g/m².

| | |
|---|---|
| Product of esterification of 1,2-naphthoquinonediazide-5-sulfonyl chloride with 2,3,4-trihydroxybenzophenone | 0.75 g |
| Polymer set forth in Table 1 | 2.0 g |
| 2-(p-Butoxyphenyl)-4,6-bis (trichloromethyl)-s-triazine | 0.02 g |
| Naphthoquinone-1,2-diazide-4-sulfonic chloride | 0.03 g |
| Crystal violet | 0.01 g |
| Oil blue #603 (available from Orient Chemical Industry Co., Ltd.) | 0.015 g |
| 1-Methoxy-2-propanol | 18 g |
| 2-Methoxyethyl acetate | 12 g |

These photosensitive lithographic plates were each exposed to light from a 2 KW metal halide lamp positioned 1 meter apart therefrom through a positive transparent original for 40 seconds.

The photosensitive lithographic plates thus exposed were each developed under the following conditions. In more detail, a developer (pH 10) obtained by four-fold diluting the following mother solution of developer 1 and a finisher FP-2 available from Fuji Photo Film Co., Ltd. were charged into an automatic developing machine Stablon 900 NP available from Fuji Photo Film Co., Ltd. The photosensitive lithographic plates were each developed at a developer temperature of 30°C for 30 hours in the automatic developing machine.

| | |
|---|---|
| Sodium carbonate monohydrate | 7 g |
| Sodium hydrogencarbonate | 4.5 g |
| Ethylenediaminetetraacetic acid | 2 g |
| Water | 100 g |

The photosensitive lithographic plates thus developed were then examined to see if an image was obtained.

The image-forming properties of photosensitive lithographic plates on which the photosensitive layer had been left undeveloped were evaluated as "bad" (underdevelopment). The image-forming properties of photosensitive lithographic plates on which the photosensitive layer had been entirely dissolved away were evaluated as "bad" (overdevelopment). The image-forming properties of photosensitive lithographic plates on which a positive image had been obtained were evaluated as "good". The image-forming properties intermediate between "good" and "bad" were represented by "fair".

The photosensitive lithographic plates on which an image had been obtained were then processed in accordance with an ordinary method to obtain lithographic plates. The lithographic plates thus obtained were each mounted on an offset printing machine for printing to effect press life test. Lithographic plates having a poor press life were worn away on the image area with a small number of printing papers and then could no longer adsorb a printing ink and give desired printed matters.

In order to evaluate the latitude in proper development conditions (development tolerance), the change in tone reproducibility from development by dipping for 5 minutes to development by dipping for 30 seconds was determined. Those showing little change were evaluated as "good". Those showing a great change were evaluated as "bad". Those intermediate between "good" and "bad" were evaluated as "fair". The results are set forth in Table 1.

A compound (Polymer No. C-1) which is disclosed in JP-A-63-226641 but is not within the scope of this application and a compound (Polymer No. C-2) which is disclosed in Japanese Patent Application No. 5-170484 but is not within the scope of this application are shown below.

As is apparent from the results shown in Table 1, the photosensitive compositions of the present invention exhibit extremely excellent properties.

**Table 1:**

| Kind and properties of polymer | | | | |
|---|---|---|---|---|
| Experiment No. | Polymer | Image-forming properties | Development time tolerance | Press life |
| Example 1 | No. 1 | good | good | 200,000 |
| " 2 | No. 2 | good | good | 180,000 |
| " 3 | No. 3 | good | good | 210,000 |
| " 4 | No. 5 | good | good | 220,000 |
| Comparative Example 1 | 8:2 (molar ratio) copolymer of methyl methacrylate and methacrylic acid | bad (over-development) | - | - |
| " 2 | Polyhydroxystyrene | fair | fair | 90,000 |
| " 3 | m-Cresol novolak resin | bad - (under-development) | - | - |
| " 4 | No. C-1 | bad (over-development) | - | - |
| " 5 | No. C-2 | good | good | 160,000 |

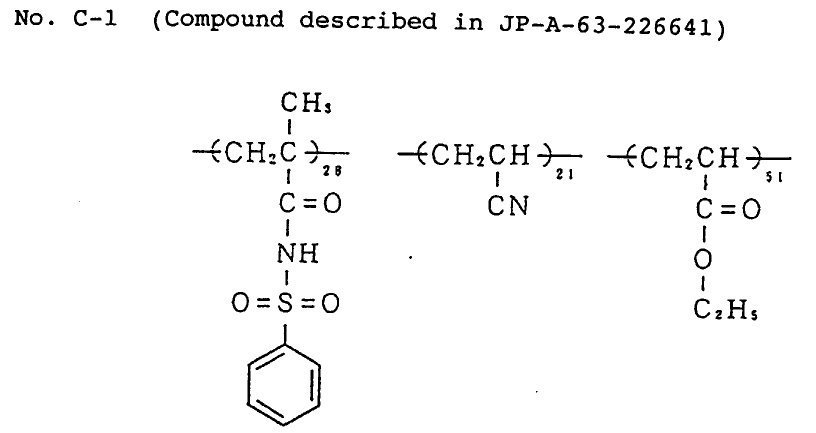

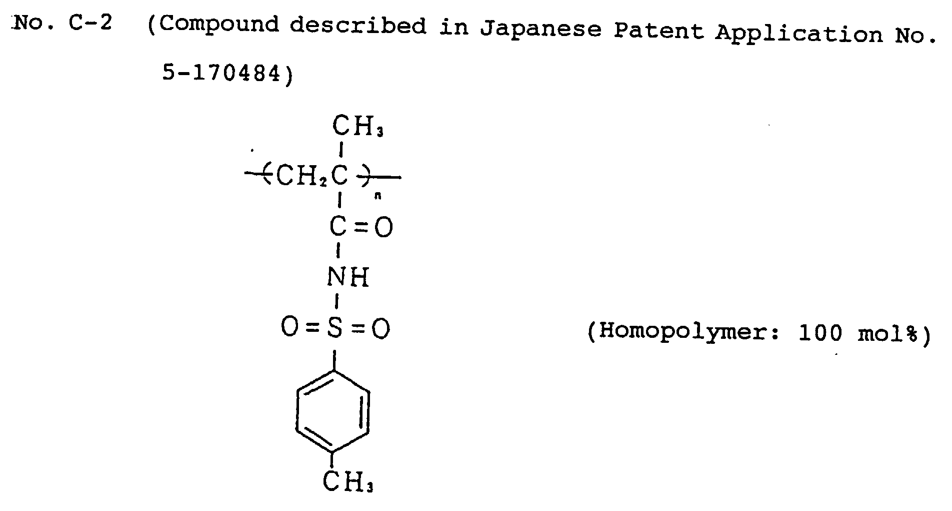

### EXAMPLES 5 - 8

A substrate (I) was prepared by treating an aluminum plate in the same manner as in Examples 1 to 4. The following photosensitive solutions (B) were each applied to the substrate (I) by means of a whirler, and then dried at a temperature of 100°C for 1 minute to obtain positive-working photosensitive lithographic plates. The coated amount after drying was about 1.7 g/m².

| | |
|---|---|
| Product of esterification of 1,2-diazonaphthoquinone-5-sulfonyl chloride with pyrogallol-acetone resin (described in Example 1 of U.S. Patent 3,635,709) | 0.45 g |
| Polymer set forth in Table 2 | 1.2 g |
| Naphthoquinonediazide-1,2-diazide-4-sulfonic chloride | 0.01 g |
| Tetrahydrophthalic anhydride | 0.02 g |
| Benzoic acid | 0.02 g |
| Pyrogallol | 0.05 g |
| 4-[p-N,N-bis(ethoxycarbonylmethyl) aminophenyl]-2,6-bis(trichloromethyl)-S-triazine | 0.02 g |
| N-(1,2-naphthoquinone-2-diazide-4-sulfonyloxy)cyclohexane-1,2-dicarboxylic imide | 0.01 g |
| Dye obtained by replacing paired ion in victoria pure blue BOH (available from Hodogaya Chemical Co., Ltd.) by 1-naphthalenesulfonic acid | 0.045 g |
| Megafac F-177 (fluorinic surface active agent available from Dainippon Ink & Chemicals, Inc.) | 0.015 g |
| Methyl ethyl ketone | 25 g |
| Propylene glycol monomethyl ether | 10 g |

These photosensitive lithographic plates were each exposed to light from a 3 KW metal halide lamp positioned 1 meter apart therefrom through a transparent positive film in a vacuum printing frame for 1 minute. The photosensitive lithographic plates thus exposed were each developed with a 3.5% aqueous solution (pH = 12.4) of sodium silicate SiO₂/Na₂O (molar ratio: 2.0) at a temperature of 30°C for 30 minutes.

The photosensitive lithographic plates thus developed were then examined in the same manner as in Examples 1 to 4 to see if an image was obtained. The photosensitive lithographic plates on which an image had been obtained were then processed in accordance with an ordinary method to obtain lithographic plates. The lithographic plates thus obtained were each mounted on an offset printing machine for printing to effect press life test. The latitude in proper development conditions (development tolerance) was evaluated in the same manner as in Examples 1 to 4. The results are set forth in Table 2.

A compound (Polymer No. C-3) which is disclosed in JP-A-63-226641 but is not within the scope of this application and a compound (Polymer No. C-4) which is disclosed in Japanese Patent Application No. 5-170484 but is not within the scope of this application are shown below.

As is apparent from the results shown in Table 2, the photosensitive compositions of the present invention exhibit extremely excellent properties.

**Table 2:**

| Kind and properties of polymer | | | | |
|---|---|---|---|---|
| Experiment No. | Polymer | Image-forming Properties | Development time tolerance | Press life |
| Example 5 | No. 6 | good | good | 180,000 |
| " 6 | No. 7 | good | between good and fair | 160,000 |
| " 7 | No. 9 | good | good | 200,000 |
| " 8 | No. 18 | good | good | 210,000 |
| | No. 19 | good | good | 200,000 |
| Comparative Example 6 | No. C-3 | bad (over-development) | - | - |
| " 7 | No. C-4 | good | good | 130,000 |

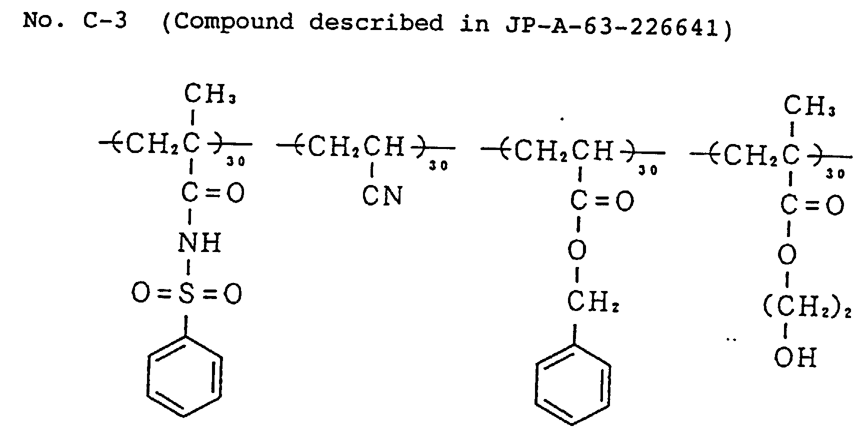

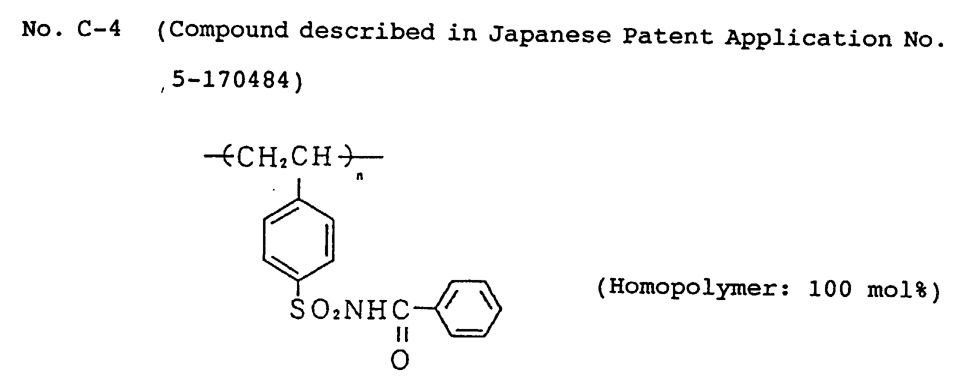

The photosensitive composition comprising a polymer containing an active imino group of the present invention exhibits an excellent developability and press life.

## Claims

1. A positive-working photosensitive composition, which comprises a polymer having a structural unit represented by the following formula [1] in a proportion of from 3 mol% to less than 60 mol%: 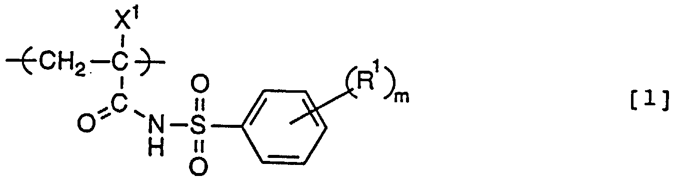 wherein
X¹ represents a hydrogen atom, a halogen atom or an alkyl group having from 1 to 4 carbon atoms;
R¹ represents an alkyl group having from 1 to 6 carbon atoms, a halogen atom or an alkoxy group having from 1 to 6 carbon atoms; and
m represents an integer of from 1 to 5,
with the proviso that said polymer is not represented by

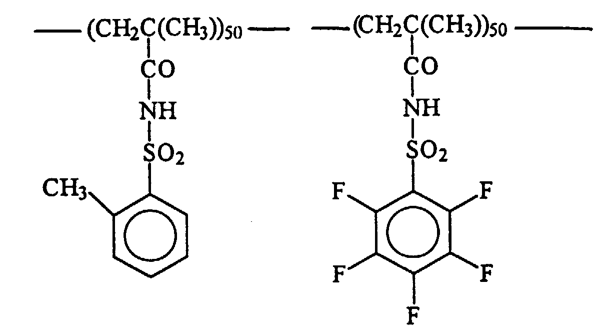

2. The positive-working photosensitive composition of claim 1, which comprises
a polymer having the following structural units (a), (b) and (c) in a proportion of from 3 mol% to less than 60 mol%, from 3 mol% to 80 mol%, and from 3 mol% to 80 mol%, respectively:
(a) structural unit represented by the above-described formula [1];
(b) structural unit represented by the following formula [2]; and
(c) structural unit represented by the following formula [3]: 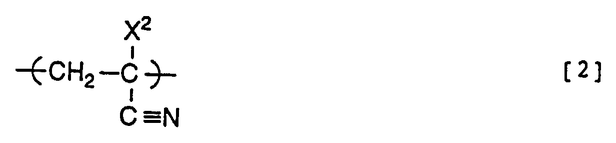 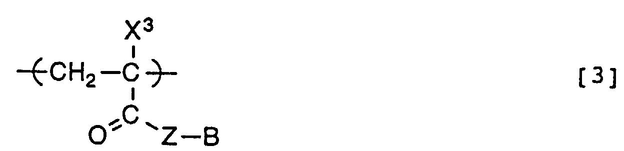 wherein
X² represents a hydrogen atom, a halogen atom or an alkyl group having from 1 to 4 carbon atoms;
X³ represents a hydrogen atom, a halogen atom or an alkyl group having from 1 to 4 carbon atoms;
Z represents an oxygen atom; and
B represents an alkyl group substituted with a phenyl group.

3. A process for image formation, which comprises the steps of imagewise exposing a photosensitive material comprising a photosensitive layer containing the photosensitive composition according to claim 1 or 2, and then developing the photosensitive material with an aqueous alkaline solution having a pH of 12.5 or less.

## Patentansprüche

1. Positiv-arbeitende lichtempfindliche Zusammensetzung, umfassend ein Polymer mit strukturellen Einheiten gemäß der folgenden Formel (1) in einem Anteil von 3 Mol-% bis weniger als 60 Mol-%: 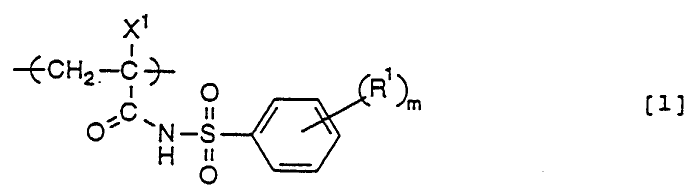 worin
X¹ ein Wasserstoffatom, ein Halogenatom oder eine Alkylgruppe mit 1 bis 4 Kohlenstoffatomen bedeutet;
R¹ bedeutet eine Alkylgruppe mit 1 bis 6 Kohlenstoffatomen, ein Halogenatom oder eine Alkoxygruppe mit 1 bis 6 Kohlenstoffatomen; und
m bedeutet eine ganze Zahl im Bereich von 1 bis 5,
mit der Maßgabe, daß das Polymer nicht durch 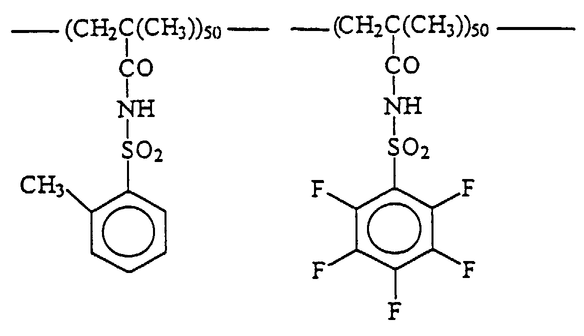 dargestellt ist.

2. Positiv-arbeitende lichtempfindliche Zusammensetzung nach Anspruch 1, umfassend ein Polymer mit den folgenden strukturellen Einheiten (a), (b) und (c) in Anteilen von jeweils 3 Mol-% bis weniger als 60 Mol-%, 3 Mol-% bis 80 Mol-%, und 3 Mol-% bis 80 Mol-%:
(a) strukturelle Einheiten, dargestellt durch die zuvor beschriebene Formel (1);
(b) strukturelle Einheiten, dargestellt durch die folgende Formel (2); und
(c) strukturelle Einheiten, dargestellt durch die folgende Formel (3): 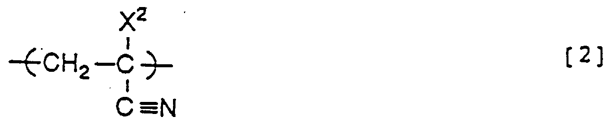 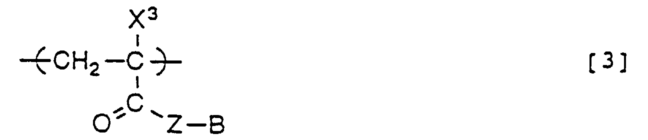 worin
X² ein Wasserstoffatom, ein Halogenatom oder eine Alkylgruppe mit 1 bis 4 Kohlenstoffatomen bedeutet;
X³ bedeutet ein Wasserstoffatom, ein Halogenatom oder eine Alkylgruppe mit 1 bis 4 Kohlenstoffatomen;
Z bedeutet ein Sauerstoffatom; und
B bedeutet eine Alkylgruppe, die mit einer Phenylgruppe substituiert ist.

3. Verfahren zur Erzeugung eines Bildes, umfassend das bildweise Belichten eines lichtempfindlichen Materials, umfassend eine lichtempfindliche Schicht, enthaltend die lichtempfindliche Zusammensetzung nach einem der Ansprüche 1 oder 2, und nachfolgend das Entwickeln des lichtempfindlichen Materials mit einer wäßrigen alkalischen Lösung mit einem pH-Wert von 12,5 oder weniger.

## Revendications

1. Composition photosensible positive qui comprend un polymère ayant une unité structurale représentée par la formule [1] suivante en une proportion de 3 mol% à moins de 60 mol% : 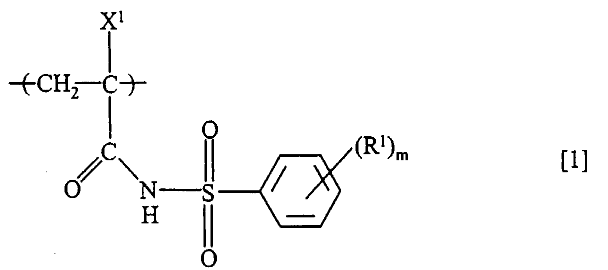 où
X¹ représente un atome d'hydrogène, un atome d'halogène ou un groupe alkyle ayant de 1 à 4 atomes de carbone ;
R¹ représente un groupe alkyle ayant de 1 à 6 atomes de carbone, un atome d'halogène ou un groupe alcoxy ayant de I à 6 atomes de carbone ; et
m représente un entier de 1 à 5,
à condition que ledit polymère ne soit pas représenté par

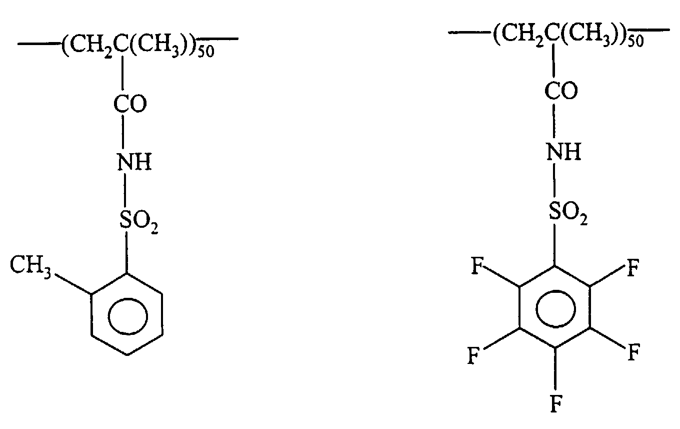

2. Composition photosensible positive selon la revendication 1 qui comprend un polymère ayant les unités structurales (a), (b) et (c) suivantes en une proportion de 3 mol% à moins de 60 mol%, de 3 mol% à 80 mol% et de 3 mol% à 80 mol%, respectivement :
(a) une unité structurale représentée par la formule [1] décrite ci-dessus ;
(b) une unité structurale représentée par la fomule [2] suivante ; et
(c) une unité structurale représentée par la formule [3] suivante : 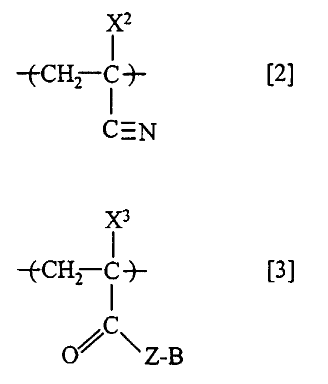 où
X² représente un atome d'hydrogène, un atome d'halogène ou un groupe alkyle ayant de 1 à 4 atomes de carbone ;
X³ représente un atome d'hydrogène, un atome d'halogène ou un groupe alkyle ayant de 1 à 4 atomes de carbone ;
Z représente un atome d'oxygène ; et
B représente un groupe alkyle substitué par un groupe phényle.

3. Procédé pour la formation d'images qui comprend les étapes d'exposition selon une image d'un matériau photosensible comprenant une couche photosensible contenant la composition photosensible selon la revendication 1 ou 2 puis le développement du matériau photosensible avec une solution alcaline aqueuse ayant un pH de 12,5 ou moins.
